# EUROPEAN PATENT APPLICATION

(11) **EP 2 930 761 A1**
(43) Date of publication of application: **14.10.2015**
(21) Application number: 13860909.4
(22) Date of filing: 02.12.2013
(51) Int. Cl.: H01L 51/50, H01L 51/56, G09F 9/00

(54) **PIXEL STRUCTURE FOR ACTIVE MATRIX DISPLAY, AND METHOD FOR MANUFACTURING SAME**

(30) Priority: 07.12.2012 KR 20120141829
(71) Applicant: Korea Electronics Technology Institute, Seongnam-si, Gyeonggi-do 463-816 (KR); Heraeus Precious Metals GmbH & Co. KG, 63450 Hanau (DE)
(72) Inventor: KIM, Yonghoon, Seongnam-si Gyeonggi-do 463-725 (KR); HAN, Chuljong, Seoul 135-942 (KR); LEE, Jeongno, Yongin-si Gyeonggi-do 448-753 (KR); YOO, Byungwook, Seongnam-si Gyeonggi-do 463-736 (KR)
(74) Representative: Heraeus IP
(86) International application number: PCT/KR2013/011067
(87) International publication number: WO 2014/088275

(57) **Abstract**

The present invention relates to a pixel structure for an active matrix display and to a method for manufacturing same, and the objective thereof is to simplify processes for manufacturing pixel electrodes and pixel defining layers and address a problem caused by a terminal which is formed at an edge part of the pixel electrode through the patterning of the pixel electrode. The pixel structure according to the present invention includes: a base substrate; a plurality of pixel circuit electrodes; an insulating layer; and a composite layer. The plurality of pixel circuit electrodes is arranged in a matrix form on the base substrate. The insulating layer is formed on the base substrate to cover the outer peripheries of the plurality of pixel circuit electrodes. The composite layer is integrally formed to cover the plurality of pixel circuit electrodes and the top of the insulating layer. In this case, the composite layer has: the conductive pixel electrodes that are formed to be respectively connected to the plurality of pixel circuit electrodes which are exposed from the insulating layer; and the non-conductive pixel defining layers on the outer peripheries of the pixel electrodes.

## Description

### [Technical Field]

The present invention relates to an active matrix display. More specifically, the present invention relates to a pixel structure of an active matrix display in which a pixel electrode and a pixel defining layer are formed in a single layer, and a method of fabricating the same.

### [Background Art]

Active matrix displays are display devices including a plurality of pixels arranged in the form of a matrix, and have been widely used in various applications. Such active matrix displays includes a panel having the pixels and a peripheral circuit to control the panel.

Active matrix displays have advantages, such as a small thickness, a light weight, and low power consumption, and have been widely used as display devices for audio/video (AV) apparatuses, office automation apparatuses, and the like.

Active matrix displays display information using light generated by pixel electrodes formed in an active matrix substrate. For example, an active matrix organic light-emitting diode (AMOLED) among the active matrix displays is a self-emissive display using a principle in which when current flows through a fluorescent or phosphor organic thin-film, electrons and holes are combined in the organic thin-film to generate light. Here, a color of light may vary depending on organic materials forming a light-emitting layer. An organic light-emitting diode (OLED) may be divided into a passive matrix light-emitting diode (PM OLED) and a passive matrix light-emitting diode (AMOLED). AMOLED is an individual-driving type in which each light-emitting device is driven, compared with PMOLED, a line-driving type in which a full line is driven to emit light.

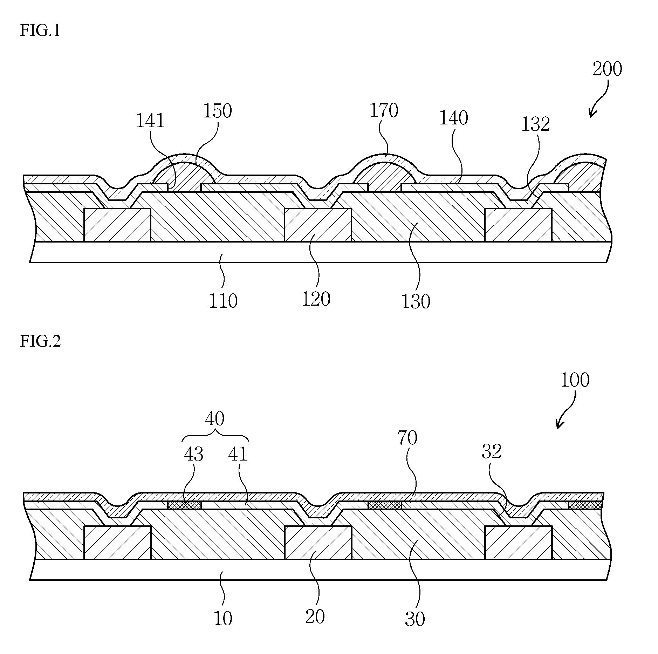

As illustrated in FIG. 1, a pixel structure 200 of a normal active matrix display has a structure in which a plurality of pixel electrodes 140 defined by a pixel-defining layer 150 are arranged in the form of a matrix on a base substrate 110.

The pixel structure 200 of the normal active matrix display may include the base substrate 110, a plurality of pixel circuit electrodes 120, a bottom insulating layer 130, the plurality of pixel electrodes 140, the pixel-defining layer 150, and a cathode layer 170. The plurality of pixel circuit electrodes 120 may be formed in the form of a matrix on the base substrate 110. The bottom insulating layer 130 may be formed between the plurality of pixel circuit electrodes 120, and the pixel circuit electrodes 120 may be exposed to the outside through contact holes 132 formed in the bottom insulating layer 130. The plurality of pixel electrodes 140a may be formed in the form of a matrix on the bottom insulating layer 130 and respectively connected to the plurality of pixel circuit electrodes 120. The insulating pixel-defining layer 150 may be formed between the plurality of pixel electrodes 140. In addition, the cathode layer 170 may be formed to cover the plurality of pixel electrodes 140 and the pixel-defining layer 150.

Here, the pixel electrodes 140 and the pixel-defining layer 150 may be independently formed by patterning using photolithography processes.

That is, the pixel electrodes 140 may be formed to be respectively connected to the plurality of pixel circuit electrodes 120 by patterning using a photolithography process, after forming an electrode layer for forming the pixel electrodes 140 on the bottom insulating layer 130 including the pixel circuit electrodes 120.

Next, a top insulating layer for forming the pixel-defining layer 150 may be formed to cover the bottom insulating layer 130 including the pixel electrodes 140. Then, the pixel-defining layer 150 covering edges of the plurality of pixel electrodes 140 may be formed by patterning using a photolithography process,

In such a manner, the pixel structure 200 of the normal active matrix display normal may require separate patterning processes using separate photolithography processes to form the pixel electrodes 140 and the pixel-defining layer 150. Thus, a manufacturing process may be complicated, and yield may be lowered due to the complicated process.

The pixel electrodes 140 may include steps 141 of edges thereof exposed by the patterning process. Although the pixel-defining layer 150 such as an organic insulating layer is formed to cover the steps 141 of the pixel electrodes 140 in order to solve a problem such as a short circuit with the cathode layer 170 formed on the pixel electrodes 140, the pixel electrodes 140 may still include steps 141 of the edges thereof and still have the short circuit with the cathode layer 170 formed on the pixel electrodes 140.

In order to suppress such a short circuit problem between the pixel electrodes 140 and the cathode layer 170, the pixel-defining layer 150 needs to be formed in consideration of an inclination angle formed by the edges of the pixel electrodes 140 and the pixel-defining layer 150, a height of each step, etc. Thus, the process of defining the pixel electrodes 140 may require considerably high skills.

In addition, since the pixel-defining layer 150 is formed of an insulating material such as a hygroscopic organic material, reliability of the active matrix display may be lowered due to moisture included in the pixel-defining layer 150.

Further, since the pixel-defining layer 150 may be formed at a higher level than the pixel electrodes 140, efficiency of the pixel electrodes 140 may be reduced compared to a case in which the pixel electrodes 140 and the pixel-defining layer 150 are formed at the same level.

### [Disclosure]

### [Technical Problem]

Accordingly, the present invention is directed to a pixel structure of an active matrix display capable of simplifying a process of forming pixel electrodes and a pixel-defining layer, and a method fabricating the same.

The present invention is also directed to a pixel structure of an active matrix display capable of improving yield by fundamentally preventing exposure of steps of edges of the pixel electrodes, and a method fabricating the same.

The present invention is also directed to a pixel structure of an active matrix display capable of solving a problem in which reliability of the active matrix display is degraded due to moisture generated by using an organic material as a pixel-defining layer, and a method fabricating the same.

The present invention is also directed to a pixel structure of an active matrix display capable of solving a problem such as a short circuit with a cathode layer occurring in interfaces between pixel electrodes and a pixel-defining layer, by forming the pixel-defining layer and the pixel-defining layer at the same level, and a method fabricating the same.

### [Technical Solution]

According to an aspect of the present invention, there is provided a pixel structure of an active matrix display including a base substrate, a plurality of pixel circuit electrodes, an insulating layer, and a composite layer. The plurality of pixel circuit electrodes are arranged in the form of a matrix on the base substrate. The insulating layer is formed on the base substrate to cover outskirts of the plurality of pixel circuit electrodes. The composite layer is integrally formed to cover the plurality of pixel circuit electrodes and the insulating layer. Here, the composite layer includes conductive pixel electrodes respectively connected to the plurality of pixel circuit electrodes exposed in the insulating layer, and a non-conductive pixel-defining layer disposed around the pixel electrodes.

In some embodiments, the composite layer may be formed based on conductive polyethylene dioxythiophene/polystyrene sulfonate (PEDT/PSS) or poly(3,4-ethylenedioxythiophene)/polystyrene sulfonate (PEDOT/PSS), the pixel-defining layer may be formed by changing the characteristic of electrical resistance of the conductive PEDT/PSS or PEDOT/PSS, and the pixel electrodes may be formed of the remaining conductive PEDT/PSS or PEDOT/PSS.

In other embodiments, the pixel electrodes and the pixel-defining layer may be formed to be coplanar.

According to another aspect of the present invention, there is provided a method of forming a pixel structure of an active matrix display including providing a base substrate including a plurality of pixel circuit electrodes and an insulating layer formed on an upper surface thereof, and forming an integrated composite layer to cover the plurality of pixel circuit electrodes and the insulating layer. The composite layer includes conductive pixel electrodes respectively connected to the plurality of pixel circuit electrodes exposed by the insulating layer, and a non-conductive pixel-defining layer disposed around the pixel electrodes.

In some embodiments, the forming of the composite layer may include forming a conductive polymer layer configured to cover the plurality of pixel circuit electrodes and the insulating layer, forming a photoresist film on the conductive polymer layer, forming an opening by removing the photoresist film on a portion to be the pixel-defining layer in the conductive polymer layer, forming the non-conductive pixel-defining layer by changing the characteristic of electrical resistance of the portion of the conductive polymer layer exposed by the opening, removing the photoresist film, and forming a cathode layer on the composite layer.

In other embodiments, when forming the non-conductive pixel-defining layer, portions covered by the photoresist film in the conductive polymer layer may be defined as the pixel electrodes by the pixel-defining layer.

In other embodiments, the composite layer may be formed based on conductive polyethylene dioxythiophene/polystyrene sulfonate (PEDT/PSS) or poly(3,4-ethylenedioxythiophene)/polystyrene sulfonate (PEDOT/PSS), the pixel-defining layer may be formed by changing the characteristic of electrical resistance of the conductive PEDT/PSS or PEDOT/PSS, and the pixel electrodes may be formed of the remaining conductive PEDT/PSS or PEDOT/PSS.

In other embodiments, the pixel electrodes and the pixel-defining layer may be formed to be coplanar.

### [Advantageous Effects]

According to the embodiment of the present invention, a composite layer in which pixel electrodes and a pixel-defining layer are formed at the same time with no additional patterning process may be fabricated by forming a conductive polymer layer to form the pixel electrodes and the pixel-defining layer on an insulating layer including pixel circuit electrodes, and changing the characteristic of electrical resistance of a portion to be the pixel-defining layer in the conductive polymer layer from conductive to non-conductive. Thus, a process of forming the pixel electrodes and the pixel-defining layer may be simplified.

In addition, yield may be improved since exposure of steps of edges of the pixel electrodes due to a conventional patterning process is fundamentally prevented by changing the characteristic of electrical resistance of the portion to be the pixel-defining layer in the conductive polymer layer from conductive to non-conductive. That is, since the pixel electrodes and the pixel-defining layer formed based on the conductive polymer layer are integrally formed, steps due to a conventional patterning process may not be generated located in the outskirts of pixel electrodes, and thus problems due to the exposure of steps may be fundamentally eliminated.

In addition, according to the embodiment of the present invention, since polyethylene dioxythiophene/polystyrene sulfonate (PEDT/PSS) or poly(3,4-ethylenedioxythiophene)/polystyrene sulfonate (PEDOT/PSS) instead of an organic material is used as the conductive composite layer, a problem in which reliability of the active matrix display is degraded due to moisture generated by using the conventional organic material as the pixel-defining layer may be solved. That is, since PEDT/PSS or PEDOT/PSS instead of an organic material is used as the conductive composite layer, the problem due to moisture is suppressed and reliability of the active matrix display may be improved.

Further, according to the embodiment of the present invention, since the pixel electrodes and the pixel-defining layer are integrally formed in one layer using the conductive polymer layer, the pixel electrodes and the pixel-defining layer may be disposed at the same level, and a short circuit problem occurring in interfaces between the pixel electrodes and the pixel-defining layer may be solved.

### [Brief Description of the Drawings]

FIG. 1 is a cross-sectional view illustrating a pixel structure of an active matrix display according to a normal technology.
FIG. 2 is a cross-sectional view illustrating a pixel structure of an active matrix display according to an embodiment of the present invention.
FIG. 3 is a process flowchart according to a method of forming the pixel structure of the active matrix display of FIG. 2.
FIGS. 4 to 9 are cross-sectional views illustrating each process according to the method of FIG. 3.

### [Modes for Carrying out the Invention]

The objects, features, and advantages of the present invention will be more clearly understood from the following detailed descriptions of embodiments taken in conjunction with the accompanying drawings. In the following description, detailed descriptions of related known functions or elements that may unnecessarily make the gist of the present invention obscure will be omitted.

The terms and words used in the specification and claims should not be construed with common or dictionary meanings, but construed as meanings and conception coinciding the spirit of the invention based on a principle that the inventors can appropriately define the concept of the terms to explain the invention in the optimum method. Therefore, embodiments described in the specification and the configurations shown in the drawings are not more than the most preferred embodiments of the present invention and do not fully cover the spirit of the present invention. Accordingly, it should be understood that there may be various equivalents and modifications that can replace those when this application is filed.

Hereinafter, various embodiments will now be described more fully with reference to the accompanying drawings.

FIG. 2 is a cross-sectional view illustrating a pixel structure of an active matrix display according to an embodiment of the present invention.

Referring to FIG. 2, a pixel structure 100 of an active matrix display according to an embodiment of the present invention includes a base substrate 10, a plurality of pixel circuit electrodes 20, an insulating layer 30, and a composite layer 40. The composite layer 40 includes a plurality of pixel electrodes 41 and a pixel-defining layer 43. The plurality of pixel circuit electrodes 20 may be arranged on the base substrate 10 in the form of a matrix. The insulating layer 30 is formed on the base substrate 10 to cover edges of the plurality of pixel circuit electrodes 20. In addition, the composite layer 40 is integrally formed to cover the plurality of pixel circuit electrodes 20 and the insulating layer 30. Here, the composite layer 40 includes the conductive pixel electrodes 41 respectively connected to the plurality of pixel circuit electrodes 20 exposed by the insulating layer 30 and the non-conductive pixel-defining layer 43 disposed around the pixel electrodes 41. The pixel structure 100 of the active matrix display according to the embodiment of the present invention may further include a cathode layer 70 formed on the composite layer 40.

As the base substrate 10, a glass substrate, a plastic substrate, or a metal substrate may be used. Here, the glass substrate may be formed of silicon oxide, silicon nitride, etc. The plastic substrate may be formed of an insulating organic material. For example, the plastic substrate may be formed of an organic material selected from the group consisting of polyethersulfone (PES), polyacrylate (PAR), polyetherimide (PEI), polyethylene naphthalate (PEN), polyethylene terephthalate (PET), polyphenylene sulfide (PPS), polyarylate, polyimide, polycarbonate (PC), cellulose triacetate (CTA), and cellulose acetate propionate (CAP), but is not limited thereto. The metal substrate may include at least one selected from the group consisting of carbon(C), iron (Fe), chrome (Cr), manganese (Mn), nickel (Ni), titanium (Ti), molybdenum (Mo), stainless steel (SUS), an Invar alloy, a ZInconel alloy, and a Kovar alloy, but is not limited thereto. The metal substrate may be a metal foil. In order for the base substrate 10 to have flexible characteristics, the plastic substrate or the metal substrate may be used.

The plurality of pixel circuit electrodes 20 may be a thin film transistor (TFT) used in an active matrix display. Although not shown in FIG. 2, the pixel circuit electrodes 20 may mainly consist of an amorphous silicon semiconductor material or a polysilicon semiconductor material, a silicon oxide insulating layer, and a metal electrode. As the pixel circuit electrodes 20, an organic thin film transistor (OTFT) using an organic material may be used.

The insulating layer 30 may be formed on the base substrate 10 and the plurality of pixel circuit electrodes 20, and contact holes 32 may be formed to expose the pixel circuit electrodes 20. Through the contact holes 32, the pixel electrodes 41 may be electrically connected to the pixel circuit electrodes 20. An inorganic insulating material or an organic insulating material may be used as the insulating layer 30. Here, the inorganic insulating material used as the insulating layer 30 may be SiO₂. More specifically, spin-on-glass (SOG) including one selected from the group consisting of siloxane, silazane, and silicate, or spin-on-dielectric (SOD) including polysilazane, which are capable of forming silicon oxide through a solution process, may be used. The organic insulating material used as the insulating layer 30 may be parylene, epoxy, polyimide (PI), polyamide (PA), polyvinyl chloride (PVC), benzocyclobutene (BCB), polyvinyl alcohol (PVA), polyvinylphenol (PVP), or cyclopentane (CyPe). As a method of forming the insulating layer 30, a solution process, such as inkjet printing, spin coating, slit coating, or screen printing, may be used. The contact holes 32 may be formed by photolithography and an etching process.

In addition, the composite layer 40 is formed based on a conductive polymer, and the plurality of pixel electrodes 41 and the pixel-defining layer 43 are integrally formed to be coplanar. Such a composite layer 40 may be formed based on a conductive polymer layer formed of a conductive polymer, such as conductive polyethylene dioxythiophene/polystyrene sulfonate (PEDT/PSS) or poly(3,4-ethylenedioxythiophene)/polystyrene sulfonate (PEDOT/PSS). In the conductive polymer layer, the pixel-defining layer 43 may be formed by changing the characteristic of electrical resistance of the conductive polymer from conductive to non-conductive, and the plurality of pixel electrodes 41 may be formed of the remaining conductive polymer.

Here, as a method of changing the characteristic of electrical resistance of the conductive polymer from conductive to non-conductive, only a portion to form the pixel-defining layer 43 in the conductive polymer may be locally wet etched or locally irradiated with ultraviolet light.

Thus, in the pixel structure 100 of the active matrix display according to the embodiment of the present invention, since the pixel-defining layer 43 and the pixel electrodes 41 may be formed together using the conductive polymer layer configured to form the pixel electrodes 41, a conventional process of forming the pixel-defining layer 43 using an organic insulating material may be omitted.

In addition, in the pixel structure 100 of the active matrix display according to the embodiment of the present invention, since the pixel electrodes 41 and the pixel-defining layer 43 are formed to be coplanar, efficiency of the pixel electrodes 41 may be improved.

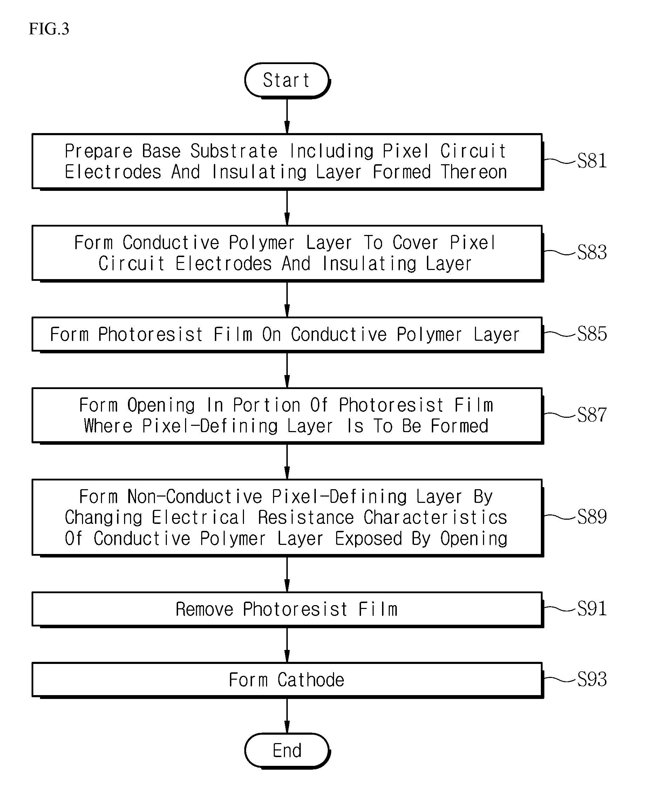

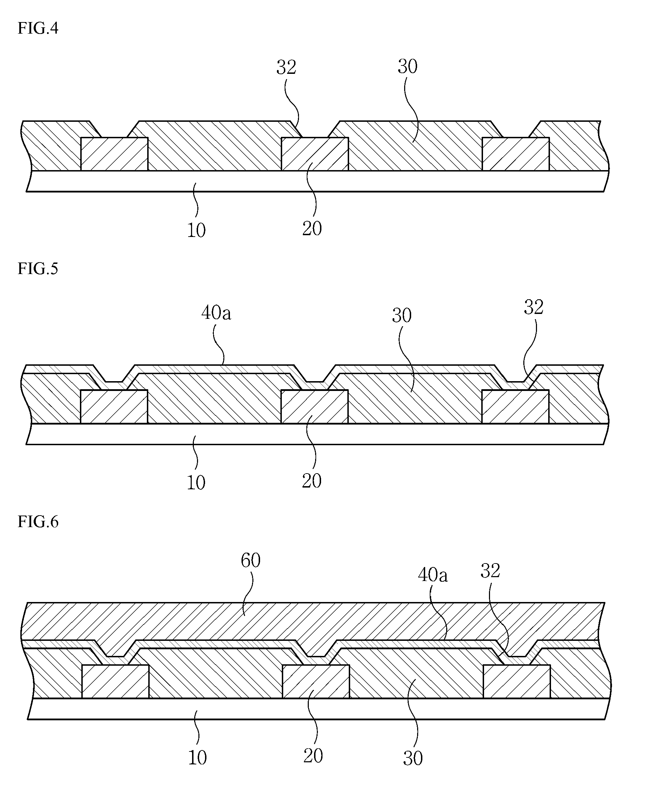

A method of forming the pixel structure 100 of the active matrix display according to the embodiment of the present invention will be described as follows with reference to FIGS. 2 to 8. Here, FIG. 3 is a process flowchart according to the method of forming the pixel structure 100 of the active matrix display of FIG. 2. In addition, FIGS. 4 to 9 are cross-sectional views illustrating each process according to the method of FIG. 3.

First, as illustrated in FIG. 4, a base substrate 10 on which a plurality of pixel circuit electrodes 20 and an insulating layer 30 are formed may be prepared in S81. The pixel circuit electrodes 20 may be exposed through contact holes 32 of the insulating layer 30.

Next, as illustrated in FIG. 5, a conductive polymer layer 40a may be formed to cover the pixel circuit electrodes 20 and the insulating layer 30 in S83. Here, as a conductive polymer for forming the conductive polymer layer 40a, PEDT/PSS or PEDOT/PSS may be used. As a method of forming the conductive polymer layer 40a, a solution process, such as inkjet printing, spin coating, slit coating, or screen printing, may be used.

Next, as illustrated in FIG. 6, a photoresist film 60 may be formed on the conductive polymer layer 40a in S85.

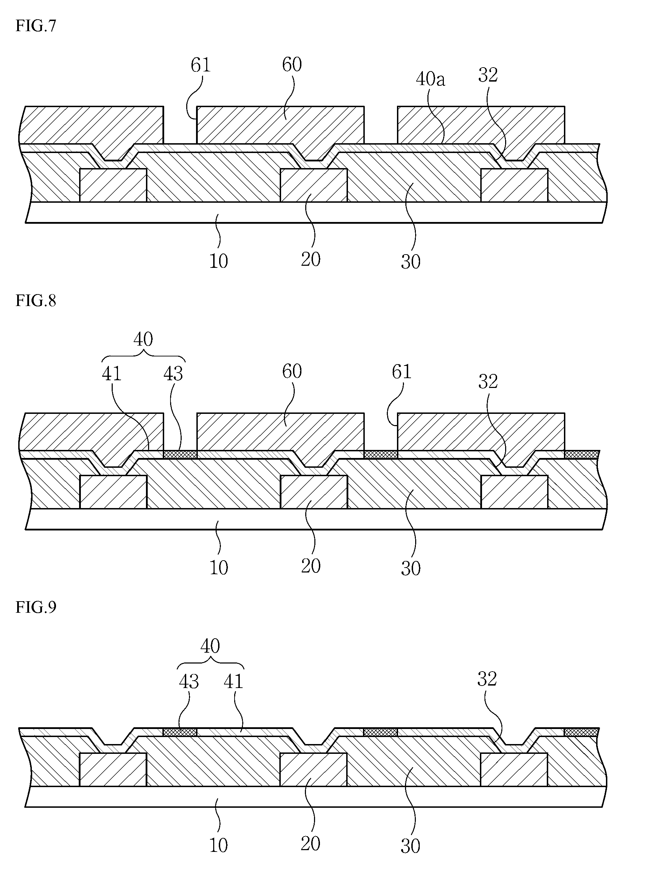

Next, as illustrated in FIG. 7, in S87, an opening 61 may be formed in a portion of the photoresist film 60 where a pixel-defining layer 43 is to be formed. That is, the opening 61 may be formed by removing the portion of the photoresist film 60 where the pixel-defining layer 43 is to be formed through an exposure and developing process on the photoresist film 60.

Next, as illustrated in FIG. 8, in S89, the non-conductive pixel-defining layer 43 may be formed by changing the characteristic of electrical resistance of a portion of the conductive polymer layer exposed by the opening 61. Here, in order to change the characteristic of electrical resistance of the portion of the conductive polymer exposed by the opening 61 from conductive to non-conductive, a wet-etch method or an ultraviolet light irradiation method may be used. That is, by immersing the base substrate 10 into a solution capable of changing electrical properties of the conductive polymer, the portion of the conductive polymer layer exposed by the opening 61 of the photoresist film 60 may be chemically changed to be non-conductive. Alternatively, the portion of the conductive polymer layer exposed by the opening 61 of the photoresist film 60 may be irradiated with ultraviolet light to be physically and chemically changed and the characteristic of electrical resistance thereof may become non-conductive.

Here, portions of the conductive polymer layer covered by the photoresist film 60 may maintain electrically conductive characteristics. Since the portion of the conductive polymer layer exposed by the opening 61 becomes the pixel-defining layer 43, the portion of the conductive polymer layer covered by the photoresist film 60 may be defined as pixel electrodes 41 by the pixel-defining layer 43.

Thus, according to the embodiment of the present invention, the pixel electrodes 41 and the pixel-defining layer 43 may be formed to be coplanar using the conductive polymer layer.

Next, as illustrated in FIG. 9, in S91, the photoresist film is removed from the composite layer 40 including the plurality of pixel electrodes 41 and the pixel-defining layer 43.

In this manner, the pixel electrodes 41 and the pixel-defining layer 43 may be formed on the conductive polymer layer at the same time in one photolithography process using the photoresist layer. Since the pixel electrodes 41 and the pixel-defining layer 43 are integrally formed based on the conductive polymer, interfaces between the pixel electrodes 41 and the pixel-defining layer 43 may be formed to be continuous. Thus, formation of steps of edges of the pixel electrodes 41 may be fundamentally blocked.

In addition, as illustrated in FIG. 2, in S93, a cathode layer 70 is formed on the composite layer 40, and the pixel structure 100 of the active matrix display according to the embodiment of the present invention may be fabricated.

The pixel structure 100 of the active matrix display according to the embodiment of the present invention may include the composite layer 40 in which the pixel electrodes 41 and the pixel-defining layer 43 are formed at the same time with no additional patterning process, since the conductive polymer layer 40a to form the pixel electrodes 41 and the pixel-defining layer 43 are formed on the insulating layer 30 including the pixel circuit electrodes 20, followed by changing the characteristic of electrical resistance of the portion to be the pixel-defining layer 43 in the conductive polymer layer 40a from conductive to non-conductive. Thus, a process of forming the pixel electrodes 41 and the pixel-defining layer 43 may be simplified.

In addition, yield may be improved since exposure of steps of edges of the pixel electrodes due to a conventional patterning process is fundamentally prevented by changing the characteristic of electrical resistance of the portion to be the pixel-defining layer 43 in the conductive polymer layer 40a from conductive to non-conductive. That is, since the pixel electrodes 41 and the pixel-defining layer 43 formed based on the conductive polymer layer 40a are integrally formed, steps due to a conventional patterning process may not be generated located in the outskirts of pixel electrodes 43, and thus problems due to the exposure of steps may be fundamentally eliminated.

In addition, according to the embodiment of the present invention, since PEDT/PSS or PEDOT/PSS instead of an organic material is used as the conductive composite layer 40, a problem in which reliability of the active matrix display is degraded due to moisture generated by using the conventional organic material as the pixel-defining layer may be solved. That is, since PEDT/PSS or PEDOT/PSS instead of the organic material is used as the conductive composite layer 40, the problem due to moisture is suppressed and reliability of the active matrix display may be improved.

Further, according to the embodiment of the present invention, since the pixel electrodes 41 and the pixel-defining layer 43 are integrally formed in one layer using the conductive polymer layer 40a, the pixel electrodes 41 and the pixel-defining layer 43 may be formed at the same level and a short circuit problem occurring in interfaces between the pixel electrodes 41 and the pixel-defining layer 43 may be solved.

Although a few embodiments have been described, it will be apparent to those skilled in the art that various modifications can be made to the above-described exemplary embodiments of the present invention without departing from the spirit or scope of the invention.

## Claims

1. A pixel structure of an active matrix display, comprising:
a base substrate;
a plurality of pixel circuit electrodes arranged in the form of a matrix on the base substrate;
an insulating layer formed on the base substrate to cover edges of the plurality of pixel circuit electrodes; and
a composite layer integrally formed to cover the plurality of pixel circuit electrodes and the insulating layer, wherein the composite layer includes conductive pixel electrodes respectively connected to the plurality of pixel circuit electrodes exposed in the insulating layer, and a non-conductive pixel-defining layer disposed around the pixel electrodes.

2. The pixel structure of an active matrix display of claim 1, wherein the composite layer is formed based on conductive polyethylene dioxythiophene/polystyrene sulfonate (PEDT/PSS) or poly(3,4-ethylenedioxythiophene)/polystyrene sulfonate (PEDOT/PSS), the pixel-defining layer is formed by changing the characteristic of electrical resistance of the conductive PEDT/PSS or PEDOT/PSS, and the pixel electrodes are formed of the remaining conductive PEDT/PSS or PEDOT/PSS.

3. The pixel structure of an active matrix display of claim 2, wherein the pixel electrodes and the pixel-defining layer are formed to be coplanar.

4. A method of forming a pixel structure of an active matrix display, comprising:
providing a base substrate including a plurality of pixel circuit electrodes and an insulating layer formed on an upper surface thereof; and
forming an integrated composite layer to cover the plurality of pixel circuit electrodes and the insulating layer, wherein the composite layer includes conductive pixel electrodes respectively connected to the plurality of pixel circuit electrodes exposed by the insulating layer, and a non-conductive pixel-defining layer disposed around the pixel electrodes.

5. The method of claim 4, wherein the forming of the composite layer comprises;
forming a conductive polymer layer configured to cover the plurality of pixel circuit electrodes and the insulating layer;
forming a photoresist film on the conductive polymer layer;
forming an opening by removing the photoresist film on a portion to be the pixel-defining layer in the conductive polymer layer;
forming the non-conductive pixel-defining layer by changing the characteristic of electrical resistance of the portion of the conductive polymer layer exposed by the opening; and
removing the photoresist film.

6. The method of claim 5, wherein when forming the non-conductive pixel-defining layer, portions covered by the photoresist film in the conductive polymer layer are defined as the pixel electrodes by the pixel-defining layer.

7. The method of claim 5, wherein the composite layer is formed based on conductive polyethylene dioxythiophene/polystyrene sulfonate (PEDT/PSS) or poly(3,4-ethylenedioxythiophene)/polystyrene sulfonate (PEDOT/PSS), the pixel-defining layer is formed by changing the characteristic of electrical resistance of the conductive PEDT/PSS or PEDOT/PSS, and the pixel electrodes are formed of the remaining conductive PEDT/PSS or PEDOT/PSS.

8. The method of claim 4, wherein the pixel electrodes and the pixel-defining layer are formed to be coplanar.
